# EUROPEAN PATENT SPECIFICATION

(11) **EP 3 933 076 B1**
(45) Date of publication and mention of the grant of the patent: **15.04.2026**
(21) Application number: 20192171.5
(22) Date of filing: 21.08.2020
(51) Int. Cl.: C30B 15/04, C30B 29/06, H10F 71/00, H10F 77/1223

(54) **METHOD FOR PREPARING MONOCRYSTALLINE SILICON**
VERFAHREN ZUR HERSTELLUNG VON MONOKRISTALLINEM SILICIUM
PROCÉDÉ DE PRÉPARATION DE SILICIUM MONOCRISTALLIN

(30) Priority: 30.06.2020 CN 202010624020
(43) Date of publication of application: 05.01.2022
(73) Proprietor: JINKO SOLAR CO., LTD, Jiangxi 334100 (CN)
(72) Inventor: HE, Lizhu, SHANGHAI (CN); YANG, Jun, SHANGHAI (CN); WANG, Peiyuan, SHANGHAI (CN); LIU, Limeng, SHANGHAI (CN); XU, Xiang, SHANGHAI (CN); BAI, Xiaolong, SHANGHAI (CN); SHANG, Weize, SHANGHAI (CN)
(74) Representative: DREISS Patentanwälte PartG mbB

(56) References cited:
- WO-A1-2017/214084
- CN-A- 105 755 532
- CN-A- 108 411 360
- CN-A- 110 158 148
- US-A1- 2013 192 516

## Description

### CROSS-REFERENCE TO RELATED APPLICATIONS

The present application claims priority to Chinese Patent Application No. 202010624020.1, filed on June 30, 2020.

### TECHNICAL FIELD

The present disclosure relates to the technical field of a solar cell and, in particular, to a method for preparing a monocrystalline silicon, a solar cell and a photovoltaic module including the prepared monocrystalline silicon.

### BACKGROUND

In existing solar cells, performances of the monocrystalline silicon and the solar cells are usually improved by doping elements into the monocrystalline silicon. For P-type Czochralski monocrystalline silicon, it is usually doped with III group elements, such as B, Ga, and In. B is usually selected as the doping element in the monocrystalline silicon, and then in a Czochralski process, it is likely to form a boron-oxygen (B-O) complexes, which will cause light induced degradation of the solar cell and thus limit a conversion efficiency of the solar cell. For the monocrystalline silicon wafer, it is a tendency to develop larger size, thinner silicon wafer, and higher mechanical strength. High mechanical strength facilitates the silicon wafer processing. Therefore, it is necessary to develop a silicon wafer that can reduce the light induced degradation of the solar cell and have high mechanical strength, so as to facilitate production of large-sized and thin silicon wafers and improve the conversion efficiency of subsequent cells.

Prior art document CN105755532A discloses a method for preparing crystalline silicon, comprising: adding polycrystalline silicon and dopant into a crucible; heating the polycrystalline silicon and dopant in the presence of protective gas to melt to a silicon melt, and enabling the silicon melt to grow a crystal; supplementing the polycrystalline silicon to form a new silicon melt, so that the resistivity of the crystal is adjusted to the target resistivity; and the new silicon melt continues to grow crystal obtain a crystalline silicon. The method can solve the problems that the crystalline silicon prepared in the prior art has many areas with low resistivity, the distribution of resistivity is not concentrated, and the yield of crystalline silicon is low.

Prior art document CN108411360A discloses a method for growing Czochralski silicon single crystal in nitrogen, comprising the steps of melting, stabilizing temperature, seeding, shouldering, growing with a constant diameter, tailing, and the like, wherein the step of growing with a constant diameter is divided into three stages, wherein the second stage is that the input gas is pure nitrogen when the diameter is equal to 200mm to 2000mm, and the crystal growth rate is greater than 84mm/hr. The cell sheet made of silicon single crystal produced by the method has a 2% reduction in fragmentation rate, a light decay of less than 1.7% and a conversion rate of more than 21%.

Prior art document WO2017/214084A1 discloses a method for preparing a single crystal silicon ingot and a wafer sliced therefrom. The ingots and wafers comprise nitrogen at a concentration of at least about 1×10¹⁴ atoms/cm³ and/or germanium at a concentration of at least about 1×10¹⁹ atoms/cm³, interstitial oxygen at a concentration of less than about 6 ppma, and a resistivity of at least about 1000 ohm•cm.

Prior art document US2013/192516A1 discloses a method of preparing a silicon melt in a crucible for use in the manufacture of cast silicon, wherein the crucible comprises an opening, an opposing bottom surface, and at least one sidewall joining the opening and the bottom surface. The method comprises charging a silicon spacer to the bottom surface of the crucible; arranging a monocrystalline silicon seed crystal on the silicon spacer such that no surface of the monocrystalline silicon material is in contact with the bottom surface of the crucible; charging polycrystalline silicon feedstock to the crucible; and applying heat through at least one of the opening and the at least one sidewall in order to form a partially melted charge of silicon in the crucible.

### SUMMARY

In view of the problems in the related art, the present disclosure provides a method for preparing a monocrystalline silicon using a Czochralski process.

The method includes: obtaining a mixture by mixing a doping source including gallium and a polycrystalline silicon; feeding the mixture into a crucible of a single crystal furnace; introducing a doping gas at least including a first amount of nitrogen into the mixture melt by the single crystal furnace, with a first ratio of the first amount of nitrogen to the doping gas being greater than or equal to 0.8; providing a seed to the molten mixture; withdrawing the seed from the molten mixture while introducing the doping gas including a second amount of nitrogen into the molten mixture, with a second ratio of the second amount of nitrogen to the doping gas being smaller than or equal to 0.1; and forming, under an atmosphere of the doping gas, a monocrystalline silicon rod by crystallizing the molten mixture around and below the seed as the seed is continually withdrawn from the molten mixture, during which upon occurrence of a shoulder of the monocrystalline silicon rod, the second amount of nitrogen is adjusted to a third amount in such a manner that a third ratio of the third amount of nitrogen to the doping gas is greater than the second ratio, and the third ratio is greater than or equal to 0.8.

During melting of the mixture, by controlling the a first ratio of the first amount of nitrogen to the doping gas to be greater than or equal to 0.8, the nitrogen element is fully incorporated into the silicon, to form the monocrystalline silicon doped with nitrogen element.

It should be noted that, when withdrawing the seed from the molten mixture, reaction of the silicon in the silicon melt will occur due to an excessive high concentration of the nitrogen in the single crystal furnace, generating Si₃N₄ particles. The Si₃N₄ particles will cause discontinuities of the prepared monocrystalline silicon rod, resulting in defects in the monocrystalline silicon rod. In order to avoid that, the ratio of the nitrogen needs to be adjusted to a relatively low value. Preferably, when withdrawing the seed from the molten mixture, the ratio of nitrogen in the doping gas (the second ratio) is smaller than or equal to 0.1, to ensure smooth seeding and improve the quality of the monocrystalline silicon rod.

In the step of forming the monocrystalline silicon rod by crystallizing the molten mixture around and below the seed as the seed is continually withdrawn from the molten mixture, the ratio of nitrogen in the doping gas is adjusted to be higher, to allow more nitrogen elements to be fully incorporated into the monocrystalline silicon rod, wherein the ratio of nitrogen in the doping gas is greater than or equal to 0.8.

Optionally, the formed monocrystalline silicon rod comprises dopants including the gallium and the nitrogen, a doping concentration of the gallium being in a range of 0.001Ω·cm to 100Ω·cm and a doping concentration of the nitrogen being in a range of 0.01ppma to 0.1ppma.

Optionally, a doping concentration of the gallium is in a range of 0.001Ω·cm to 10Ω·cm and a doping concentration of the nitrogen is in a range of 0.01ppma to 0.1ppma.

Optionally, in the method of the present disclosure, the doping source including gallium is composed of metal gallium. The metal gallium can avoid the possibility of subsequent generation of impurities such as gallium nitride in a gallium-containing doping source, which will affect the quality of the prepared monocrystalline silicon rod.

Optionally, the metal gallium is placed on a shoulder of the single crystal furnace to be melted and added. Since the metal gallium has a small segregation coefficient, it is easy to volatilize, and therefore addition of the metal gallium can compensate for loss of the gallium, to improve a utilization rate of the raw materials and reduce production costs.

It should be noted that, the doping gas can be pure nitrogen, or a mixed gas of nitrogen and argon, and the nitrogen and the argon are introduced into the single crystal furnace in at least one of the following manners:
(1) introducing the nitrogen and the argon from independent nitrogen and argon sources connected with independent mass flow meters respectively into the single crystal furnace through a three-way pipeline, and using mass flow meters to respectively control flow rates of the argon and the nitrogen;
(2) introducing the nitrogen and the argon from the independent nitrogen and 4 argon sources into the single crystal furnace through an adjustable nitrogen inlet and an adjustable argon inlet provided on the single crystal furnace; or
(3) mixing the nitrogen and the argon from the independent nitrogen and argon sources in a predetermined ratio, and then introducing the mixed nitrogen and argon gas into the single crystal furnace.

The present disclosure further provides a solar cell, and the solar cell includes a gallium- and nitrogen-doped silicon wafer, and the gallium- and nitrogen-doped silicon wafer is prepared by the method above.

In addition, the present disclosure further provides a photovoltaic module, the photovoltaic module includes a solar cell string, the solar cell string includes a plurality of solar cells, and each of the plurality of solar cells includes the gallium- and nitrogen-doped silicon wafer prepared by the method above.

The present disclosure, through introducing the nitrogen during the process of forming the Czochralski monocrystalline silicon rod using gallium-doped polycrystalline silicon materials, allows the nitrogen element to enter the monocrystalline silicon rod to prepare Czochralski monocrystalline silicon rod doped with both gallium and nitrogen, which not only solves a light attenuation problem of p-type monocrystals and a resistivity distribution problem of gallium monocrystals, but also greatly improves the mechanical strength of the monocrystalline silicon wafer. In addition, the doping of the nitrogen element can also improve defect distribution in the monocrystals, increase the mechanical strength of the monocrystalline silicon, and improve the product quality of the monocrystalline silicon.

### BRIEF DESCRIPTION OF DRAWINGS

FIG. 1 is flowchart for preparing a monocrystalline silicon using a Czochralski (Cz) process according to an embodiment of the present disclosure; and
FIG. 2 is a flowchart for preparing an exemplary monocrystalline silicon using a Czochralski process according to another embodiment of the present disclosure.

### DESCRIPTION OF EMBODIMENTS

In order to make the purpose, technical solutions, and advantages of the present disclosure clearer, the present disclosure will be further described below in detail with reference to the drawings and embodiments. It should be understood that the specific embodiments described here are only used to explain the present disclosure, and not to limit the present disclosure.

It should be understood that the term "and/or" used in the context is merely an association relationship describing associated objects. It means that there can be three kinds of relationships, for example, A and/or B may mean: A alone exists, both A and B exist, and B alone exists.

It should be understood that the terminology such as "on" and "under" described in the embodiments of the present disclosure are described from the perspective of the accompanying drawings and should not be understood as a limitation to the embodiments of the present disclosure. In addition, it should also be understood that when it is mentioned that one element is connected "on" or "under" another element, the one element can not only be directly connected "on" or "under" the another element, but also can be indirectly connected "on" or "under" the another element through an intermediate element. Unless otherwise noted in the context, the singular form expressions "a", "an" "the" and "said" used in the embodiments and appended claims of the present disclosure are also intended to represent plural forms.

If there is no special statement, all technical features and preferred features mentioned herein can be combined with each other to form a new technical solution. Unless otherwise defined or illustrated, professional and scientific terms used herein have the same meanings as those familiar to those skilled in the art.

In the present disclosure, unless otherwise specified, a numerical range "a-b" represents an abbreviated representation of a set of real numbers between a and b, including a and b, and both a and b are real numbers. For example, a numerical range "800-900" means that all real numbers between 800 and 900 have been listed herein, and "800-900" is only an abbreviated representation of the set of these numerical values.

The "range" disclosed in the present disclosure is in a form of lower and upper limits, which may include one or more lower limits and one or more upper limits, respectively.

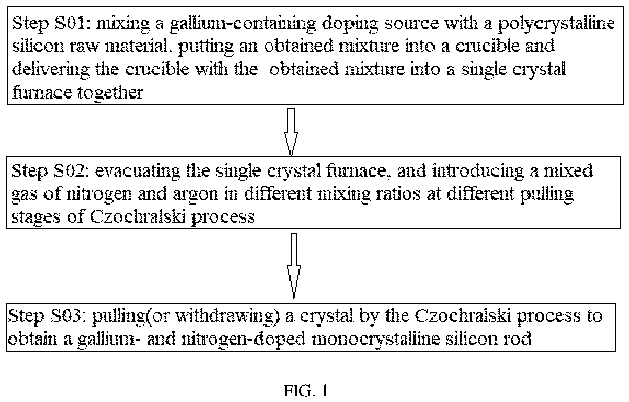

FIG. 1 is a flowchart for preparing a monocrystalline silicon using a Czochralski (Cz) process according to an embodiment of the present disclosure. In some embodiments, the monocrystalline silicon include dopants composed of gallium (Ga) and nitrogen (N) elements.

As shown in FIG. 1, the following steps are included:
step S01: mixing a gallium-containing doping source with a polycrystalline silicon raw material, putting an obtained mixture into a crucible and delivering the crucible with the obtained mixture into a single crystal furnace together;
step S02: evacuating the single crystal furnace, and introducing a mixed gas of nitrogen and argon in different mixing ratios at different pulling stages of Czochralski process; and
step S03: pulling(or withdrawing) a crystal by the Czochralski process to obtain a gallium- and nitrogen-doped monocrystalline silicon rod.

Exemplary Czochralski process may include a plurality of processing stages, for example, charging, silicon melting, seeding, necking, shouldering, crystal body growth, and tailing. Specifically, a heated crucible holds a melted form of a charged material from which the crystal is to be grown. A seed is placed at the end of a cable or rod that will enable the seed to be lowered into the melt material and then raised back out of the melt material. When the seed is lowered into the melt material, it causes a local decrease in melt temperature, which results in a portion of the melt material crystallizing around and below the seed. Thereafter, the seed is slowly withdrawn from the melt material. As the seed is withdrawn or pulled from the melt material, the portion of the newly formed crystal that remains within the melt material essentially acts as an extension of the seed and causes melt material to crystallize around and below it. This process continues as the crystal is withdrawn or pulled from the melt material, resulting in crystal body growth as the seed is continually raised. The single crystal silicon rod may be produced accordingly.

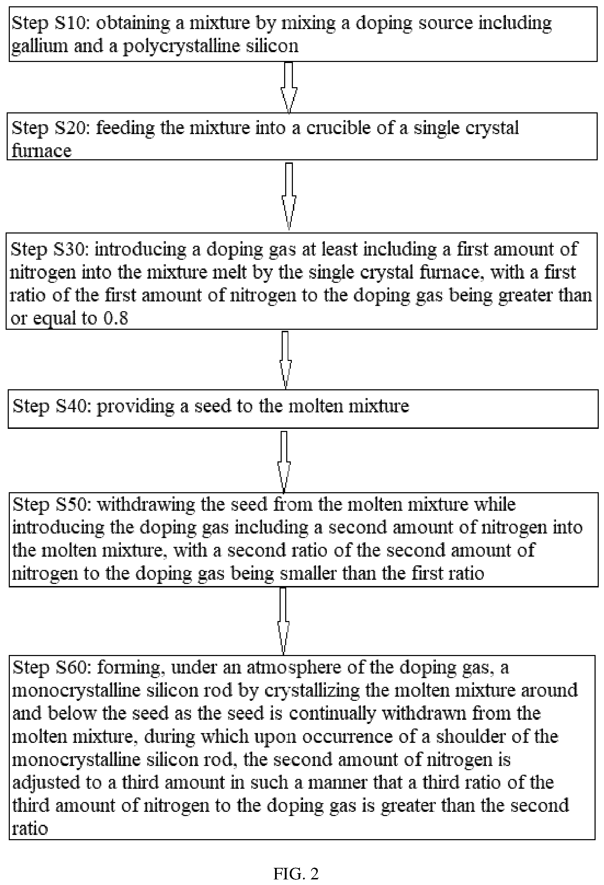

FIG. 2 is a flowchart for preparing an exemplary monocrystalline silicon using a Czochralski process according to another embodiment of the present disclosure. In some embodiments, the monocrystalline silicon include dopants composed of gallium (Ga) and nitrogen (N) elements.

As shown in FIG. 2, the following steps are included:
step S10: obtaining a mixture by mixing a doping source including gallium and a polycrystalline silicon. The doping source and the polycrystalline silicon may be mixed in accordance with a predetermined ratio. The predetermined ratio relies on a desired resistivity of the pulled monocrystalline silicon with the Czochralski process.
step S20: feeding the mixture into a crucible of a single crystal furnace (e.g., on the charging stage of the Cz process).
step S30: introducing a doping gas at least including a first amount of nitrogen into the mixture melt by the single crystal furnace (e.g., on the silicon melting stage of the Cz process), with a first ratio of the first amount of nitrogen to the doping gas being greater than or equal to 0.8.
step S40: providing a seed to the molten mixture. For example, the seed is placed at the end of a cable or rod in the single crystal furnace, which will enable the seed to be lowered into the melt material.
step S50: withdrawing the seed from the molten mixture (e.g., on the seeding stage of the Cz process) while introducing the doping gas including a second amount of nitrogen into the molten mixture, with a second ratio of the second amount of nitrogen to the doping gas being smaller than the first ratio. The second ratio is smaller than or equal to 0.1.
step S60: forming, under an atmosphere of the doping gas, a monocrystalline silicon rod by crystallizing the molten mixture around and below the seed as the seed is continually withdrawn from the molten mixture (e.g., on the necking, shouldering, and/or tailing stages of the Cz process). In some embodiments, on the shouldering stage, upon occurrence of a shoulder of the monocrystalline silicon rod, the second amount of nitrogen is adjusted to a third amount in such a manner that a third ratio of the third amount of nitrogen to the doping gas is greater than the second ratio. In The third ratio is greater than or equal to 0.8.

A gallium- and nitrogen-doped monocrystalline silicon rod, i.e., gallium- and nitrogen-doped Czochralski monocrystalline silicon rod, can be prepared by the above method(s) illustrated in FIG. 1 or FIG. 2. A gallium- and nitrogen-doped monocrystalline silicon wafer can be obtained by cutting the prepared gallium- and nitrogen-doped monocrystalline silicon rod. Each silicon rod can be cut to a plurality of slices, i.e., silicon wafers. The doped gallium basically eliminates light induced degradation of solar cells including the gallium- and nitrogen-doped monocrystalline silicon wafter, and the doped nitrogen can improve mechanical properties of the crystalline silicon and enable it to have better mechanical strength, which is convenient for subsequent processing of the silicon rod, such as improving a yield of silicon wafers, making it easy to prepare silicon wafer products having large and thin dimensions.

In the prepared gallium- and nitrogen-doped monocrystalline silicon rod, the doping concentration of gallium is in a range from 0.001Ω·cm to 100Ω·cm, and the doping concentration of nitrogen is in a range from 0.01ppma to 0.1ppma. Preferably, the doping concentration of gallium can be in a range from 0.001Ω·cm to 10Ω·cm, and the doping concentration of nitrogen can be in a range from 0.01ppma to 0.1ppma.

Merely for illustration, the gallium- and nitrogen-doped monocrystalline silicon rod can be prepared with reference to the following exemplary embodiments. However, it can be understood that the following embodiments are only exemplary and do not constitute limitations.

### Embodiment 1

The present embodiment provides a method for preparing a gallium- and nitrogen-doped monocrystalline silicon, including following steps:
(1) On the charging stage, a gallium-containing doping source and a polycrystalline silicon material can be mixed and fed into a crucible of a single crystal furnace. For example, the mixed materials of the pure gallium and the polycrystalline silicon are placed in a quartz crucible in the single crystal furnace. In some embodiments, the gallium-containing doping source includes but not limited to metal gallium, gallium-containing compounds, gallium-containing alloys, or the like. In some embodiments, in case that other impurities in the doping source are introduced in the crystal withdrawing, preferably, the gallium-containing doping source is composed of metal gallium.
   In some examples, the gallium-containing doping source and the polycrystalline silicon material can be added in various ways. For example, they can be added through a re-charging tube, and multiple re-charging (that is, the RCZ technology) is currently one of the production technologies commonly used by manufacturers of the monocrystalline silicon. Based on the traditional process of pulling one monocrystalline silicon rod once per run, the multiple re-charging process is a process in which after the first monocrystalline silicon rod (with a certain amount of molten silicon remaining in the crucible) is pulled out, the polycrystalline silicon is recharged into the crucible through the re-charging tube, and then the second, third or even more monocrystalline silicon rod is pulled similarly as the first one. This process increases the capacity in a single run and reduces time for blow-out and blow-in the furnace, thereby increasing the proportion of pulling time in the total operating time, and the costs of quartz crucible and crystal pulling are reduced. For example, the gallium-containing doping source and the polycrystalline silicon material may be added through an external feeder. The external feeder is a material feeding device used in a Continuous Czocharlski method (i.e., CCZ method). In the continuous Czochralski method, the withdrawing of the crystal rod and the material feeding and melting are performed simultaneously. The single crystal furnace of the CCZ method is equipped with a funnel for storing silicon raw material particles and the funnel is connected to a vibrating feeder. While withdrawing the crystal rod, the raw material is continuously added through the external feeder to the crucible to be melted, so as to realize the continuous withdrawing of the monocrystalline silicon rod. The use of the CCZ method and the external feeder greatly improves a production efficiency.
(2) On the silicon melting stage, the silicon is melted by the single crystal furnace, during which a doping gas containing at least nitrogen is introduced, and a first ratio of the nitrogen to the doping gas is greater than or equal to 0.8. For example, the first ratio is 0.8 to 1.0. In some examples, the doping gas can also function as a protective gas. In some embodiments, the doping gas further includes argon. The doping gas can be designated as a mixed gas including the nitrogen gas and the argon gas.

In some examples, the doping gas is introduced into the single crystal furnace by at least one of the following manners:
1) The nitrogen and the argon from independent nitrogen and argon sources connected with independent mass flow meters respectively are introduced into the single crystal furnace through a three-way pipeline, and the mass flow meters are used to respectively control flow rates of the argon and the nitrogen. The three-way pipeline may be a three-way valve device, and the three-way valve device is at least partially arranged outside the furnace.
2) The nitrogen and the argon from the independent nitrogen and argon sources are introduced into the single crystal furnace through an adjustable nitrogen inlet and an adjustable argon inlet provided on the single crystal furnace;
3) The nitrogen and the argon from the independent nitrogen and argon sources are mixed in a predetermined ratio, and then the mixed nitrogen and argon gas is introduced into the single crystal furnace. For example, the predetermined ratio is the first ratio described above. In some examples, in the stage of feeding material to the crucible of the single crystal furnace, the nitrogen and the argon from the independent nitrogen and argon sources are mixed in a ratio of 0.8, 085, 0.9, or 0.95 (nitrogen/(argon+nitrogen)), and then the mixed nitrogen and argon gas are introduced into the single crystal furnace. In a stage of withdrawing the seed from the molten mixture, the nitrogen and the argon from the independent nitrogen and argon sources are mixed in a ratio of 0.05 or 0.1 (nitrogen/(argon+nitrogen)), and then the mixed nitrogen and argon gas is introduced into the single crystal furnace. The mixed gas containing nitrogen and argon that have been mixed in the predetermined ratio is introduced into the single crystal furnace, and a stable gas atmosphere can be therefore formed, which is conducive to obtaining a monocrystalline silicon rod of uniform quality.

In an example, the single crystal furnace is evacuated, and then the nitrogen and the argon from independently adjustable nitrogen and argon sources are introduced into the single crystal furnace through the three-way pipeline, and the ratio of the nitrogen to the total gas is adjusted to 0.8. During melting the polysilicon materials, heating is performed with a heater, a rotation speed of the quartz crucible is adjusted, and a pressure in a cavity of the single crystal furnace is maintained at 13 Torr by controlling a throttle opening of a vacuum pump.

When the silicon is being melt, attention should be paid to check if there are Si₃N₄ particles formed. If so, slag handling is carried out in time.

(3) On the stage of the seeding, a seed is provided to the molten mixture, and then withdrawn from the molten mixture while introducing the doping gas. In this process, the ratio of nitrogen to the doping gas is adjusted to a second ratio, and the second ratio is smaller than the first ratio. The second ratio is smaller than or equal to 0.1. It should be noted that during the seeding process, it is necessary to maintain a relatively small amount of nitrogen, to avoid the formation of the Si₃N₄ particles. If the Si₃N₄ particles are formed, the slag handling is carried out in time.

In some examples, the ratio of the nitrogen is gradually reduced through the mass flow meter connected with the nitrogen source, and the protective gas in the single crystal furnace is replaced with argon; then a nitrogen flow is increased gradually, to adjust the ratio of the nitrogen in the protective gas (the nitrogen and the argon) to 0.1; the molten silicon is thermally insulated, to ensure that the temperature and flowing of the molten silicon are stable; a seed crystal is fixed on a seed shaft to rotate; the seed crystal is slowly lowered, and paused at a certain distance (about 10mm) from a liquid surface of the molten silicon, and when the temperature of the seed crystal is close to the temperature of the silicon melt, the seed crystal is gently immersed in the silicon melt; and then the seed crystal is lifted and withdrawn from the melt to form the monocrystalline silicon.

(4) On the stage of the necking, the seed crystal is up-lifted quickly, to make a diameter of newly crystallized monocrystalline silicon reach 3mm, a length be about 6-10 times of the diameter of the crystal at this time; and the rotation speeds of the seed crystal and the quartz crucible are adjusted, to reduce a local diameter of the monocrystalline silicon.

(5) On the stage of the shouldering, the speed for withdrawing the seed (also referred to as pulling speed) is reduced to control the diameter of the crystal to a desired size. On this stage, a doping source including gallium is added at the same time. Preferably, the doping source including gallium is composed of metal gallium. The metal gallium can avoid the possibility of subsequent generation of impurities such as gallium nitride in a gallium-containing doping source, which will affect the quality of the prepared monocrystalline silicon rod. In some examples, since the volatility coefficient of gallium is relatively large, it is easy to result in volatilization of the gallium material, and in order to compensate for the loss of the gallium material, the elemental gallium is placed on a shoulder of the monocrystalline silicon rod to be re-melted and re-added.

(6) Upon occurrence of a shoulder of the monocrystalline silicon rod (e.g.,during the body growth and the tailing stages), the nitrogen in the doping gas is adjusted to a third ratio, the third ratio being larger than the second ratio in the seeding stage. The ratio of the nitrogen in the protective gas (nitrogen and argon) is gradually adjusted to be greater than or equal to 0.8 by the mass flow meters; then the rotation speed of the crystal is adjusted to 3-12rpm, and a reverse rotation speed of the quartz crucible is adjusted to 2-10 rpm, to allow the crystal to grow with a constant diameter.

(7) Under the atmosphere of the doping gas with the third ratio, the diameter of the crystal gradually decreases as the crystal is lifted from the melt, the temperature is lowered, cooling is performed, and the monocrystalline silicon rod is taken out to obtain a gallium- and nitrogen-doped monocrystalline silicon rod.

After the tailing stage, the crystal is cooled, the gallium- and nitrogen-doped monocrystalline silicon can be obtained, in which a doping concentration of gallium is 0.001Ω·cm to 100Ω·cm, and a doping concentration of nitrogen is 0.01ppma to 0.1ppma. Preferably, the doping concentration of gallium is 0.001Ω·cm to 10Ω·cm, and the doping concentration of nitrogen is 0.01ppma to 0.1ppma.

### Embodiment 2

The present embodiment provides the preparation of a gallium- and nitrogen-doped Czochralski monocrystalline silicon rod by charging the materials using the re-charging tube.
(1) On the charging stage, elemental gallium as a dopant and a polycrystalline silicon material are mixted, the mixed material is placed in the quartz crucible and the quartz crucible together with the mixed material is delivered to a re-feeding single crystal furnace. The mixed material of the polycrystalline silicon and the elemental gallium needs to be placed in the quartz crucible.
(2) On the silicon melting stage, the single crystal furnace is evacuated, then nitrogen and argon from independently adjustable nitrogen and argon sources are introduced into the single crystal furnace through a three-way valve, and the ratio of the nitrogen to the mixed gas (nitrogen and argon) is adjusted to 0.8. When beginning melting of the silicon, heating is performed with a heater, a rotation speed of the quartz crucible is adjusted. A pressure in a cavity of the single crystal furnace is maintained at 0.7kPa by controlling a throttle opening of a vacuum pump.
   When melting silicon, attention should be paid to check if there are Si₃N₄ particles formed. If so, slag handling is carried out in time.
(3) On the stage of the seeding, the ratio of the nitrogen is gradually reduced through mass flow meters connected to the independently adjustable nitrogen and argon sources, the protective gas in the single crystal furnace is replaced with argon, and a nitrogen flow is gradually reduced, to adjust the ratio of the nitrogen in the protective gas (nitrogen and argon) to 0.1; the molten silicon is thermally insulated, to ensure that a temperature and flowing of the molten silicon are stable; a monocrystalline seed crystal is fixed on a seed crystal shaft to rotate with the seed crystal shaft; the seed crystal is slowly lowered, and paused at about 10mm from a liquid surface of the molten silicon, and when the temperature of the seed crystal is close to the temperature of the silicon melt, the seed crystal is gently immersed in the silicon melt; and then the seed crystal is lifted and withdrawn from the silicon melt to form the monocrystalline silicon.
(4) On the stage of the necking, the seed crystal is lifted quickly, to make a diameter of newly crystallized monocrystalline silicon reach 3mm, a length be about 6-10 times of the diameter of the crystal at this time; and the rotation speeds of the seed crystal and the quartz crucible are adjusted, to reduce a local diameter of the monocrystalline silicon.
(5) On the stage of the shouldering, the speed for withdrawing the seed is reduced, to control the diameter of the crystal to a desired size.
(6) Upon occurrence of a shoulder of the monocrystalline silicon rod, the ratio of the nitrogen in the protective gas (nitrogen and argon) is gradually adjusted to be 0.9 by the mass flow meters; and then the rotation speed of the crystal is adjusted to 3-12rpm, and a reverse rotation speed of the quartz crucible is adjusted to 2-10rpm, to allow the crystal to grow with a constant diameter.
(7) Under the atmosphere of the doping gas with the ratio of 0.9, the diameter of the crystal gradually decreases as the crystal is lifted from the melt; the temperature is lowered, cooling is performed, and the monocrystalline silicon rod is taken out, to obtain a gallium- and nitrogen-doped monocrystalline silicon rod in which a doping concentration of gallium is 10Ω·cm and a doping concentration of nitrogen is 0.1 ppma.
(8) Re-charging and crystal pulling: after taking out a monocrystalline silicon rod segment obtained in step (7), the re-charging tube containing the gallium and the polycrystalline silicon raw material is placed in an auxiliary chamber of the single crystal furnace, and a gate valve is then closed. In a secondary feeding process, a small-particle polycrystalline silicon material is selected for re-charging. At the same time, the power of the heater in the single crystal furnace is reduced to 40-45kW, the surface temperature of the remaining melt in the quartz crucible was reduced to about 1400°C and crystallization occurred. The rotation speed of the crucible is reduced, the gate valve is opened, the re-charging tube enters a main chamber of the single crystal furnace, the re-charging tube is lowered to be above the quartz crucible, and a feeding port of the re-charging tube is opened, to allow the polycrystalline silicon raw material to be poured into the quartz crucible. The above steps (1) to (7) are repeated until multiple monocrystalline silicon rods are pulled.

The multiple re-charging method of the Czochralski monocrystalline silicon raw material of the present embodiment can increase the proportion of pulling time in the total running time of the furnace, greatly improve the production efficiency, reduce the production cost of monocrystalline silicon, and provide strong technical support for the manufacture of monocrystalline silicon and solar cells.

### Comparative example

The steps of this comparative example are the same as those in Embodiment 2, except that: in the seeding operation of step (3), the ratio of the nitrogen in the protective gas was not reduced. In the seeding stage, the ratio of the nitrogen in the protective gas is still 0.8. Under this condition, the inventor found that a large number of particles were generated on the molten silicon surface, which were detected as Si₃N₄ particles. It is found that Si₃N₄ particles are caused by the reaction between silicon and nitrogen due to the high concentration of nitrogen in the process of seeding, resulting in the formation of fine Si₃N₄ particles. Once the Si₃N₄ particles floating on the surface of melt come into contact with the growing monocrystalline silicon, it will lead to the broken ridge of single crystal and thus lose its structure. After research and adjustment, the ratio of nitrogen in the process of seeding in the protective gas is adjusted to a lower value, which can avoid the single crystal broken ridge caused by the formation of Si3N4 particles.

Because the monocrystalline silicon rod prepared by the method of the present disclosure is doped with nitrogen in a certain ratio, the silicon rod has relatively high mechanical strength, and since the silicon rod is doped with the gallium, the light induced degradation of a solar cell can be reduced, which is beneficial to improve a conversion efficiency of the solar cell and achieve large size and thinning of the silicon wafer.

A solar cell can be prepared based on the monocrystalline silicon. The solar cell includes a gallium- and nitrogen-doped silicon wafer, and the gallium- and nitrogen-doped silicon wafer can be obtained by cutting the gallium- and nitrogen-doped silicon rod prepared by the method described above. For example, the solar cell is formed by performing texturing, diffusion, laser SE, etching, thermal oxygenation, passivation treatment, screen printing, and sintering for the gallium- and nitrogen-doped silicon wafer. The solar cell includes the gallium- and nitrogen-doped silicon wafer, and passivation layers and electrodes on front and back sides of the gallium- and nitrogen-doped silicon wafer.

A photovoltaic module can be formed. The photovoltaic module includes at least one solar cell string. The solar cell string includes a plurality of solar cells, which each includes the gallium- and nitrogen-doped silicon wafer obtained by cutting the gallium- and nitrogen-doped silicon rod prepared by the above method. For example, at least one solar cell string each composed of the prepared solar cells is obtained, a welding tape is used to weld the cells in series, and through a lamination process, a back plate, ethylene-vinyl acetate copolymer (EVA) and the solar cells are laminated in a certain order, subsequently, the laminated structure is encapsulated, and a border is instated to form the photovoltaic module. The solar cell can convert received light energy into electrical energy. The photovoltaic module transfers the electrical energy to a load (e.g., an inverter).

The above descriptions are only preferred examples of the present disclosure and are not intended to limit the present disclosure. For those skilled in the art, the present disclosure can have various modifications and changes.

## Claims

1. A method for preparing a monocrystalline silicon using a Czochralski process, comprising:
obtaining a mixture by mixing a doping source including gallium and a polycrystalline silicon;
feeding the mixture into a crucible of a single crystal furnace;
introducing a doping gas at least including a first amount of nitrogen into the mixture melt by the single crystal furnace, wherein a first ratio of the first amount of nitrogen to the doping gas is greater than or equal to 0.8;
providing a seed to the molten mixture;
withdrawing the seed from the molten mixture while introducing the doping gas including a second amount of nitrogen into the molten mixture, wherein a second ratio of the second amount of nitrogen to the doping gas is smaller than or equal to 0.1; and
forming, under an atmosphere of the doping gas, a monocrystalline silicon rod by crystallizing the molten mixture around and below the seed as the seed is continually withdrawn from the molten mixture, wherein upon occurrence of a shoulder of the monocrystalline silicon rod, the second amount of nitrogen is adjusted to a third amount in such a manner that a third ratio of the third amount of nitrogen to the doping gas is greater than the second ratio, and the third ratio is greater than or equal to 0.8.

2. The method according to claim 1, wherein the formed monocrystalline silicon rod comprises dopants including the gallium and the nitrogen, a doping concentration of the gallium being in a range of 0.001Ω·cm to 100Ω·cm and a doping concentration of the nitrogen being in a range of 0.01ppma to 0.1ppma.

3. The method according to claim 1, wherein the formed monocrystalline silicon rod comprises dopants including the gallium and the nitrogen, a doping concentration of the gallium being in a range of 0.001Ω·cm to 10Ω·cm and a doping concentration of the nitrogen being in a range of 0.01ppma to 0.1ppma.

4. The method according to claim 1, wherein the doping source including gallium is metal gallium.

5. The method according to claim 1, wherein the doping gas further comprises argon, wherein the nitrogen and the argon are introduced into the single crystal furnace through at least one of:
(1) introducing the nitrogen and the argon from independent nitrogen and argon sources connected with independent mass flow meters respectively into the single crystal furnace through a three-way pipeline, and using the mass flow meters to respectively control flow rates of the argon and the nitrogen;
(2) introducing the nitrogen and the argon from the independent nitrogen and argon sources into the single crystal furnace respectively through an adjustable nitrogen inlet and an adjustable argon inlet provided on the single crystal furnace; or
(3) mixing the nitrogen and the argon from the independent nitrogen and argon sources in a predetermined ratio, and introducing the mixed nitrogen and argon gas into the single crystal furnace.

## Patentansprüche

1. Verfahren zum Herstellen von monokristallinem Silizium unter Verwendung eines Czochralski-Prozesses, umfassend:
Erhalten einer Mischung durch Mischen einer Dotierquelle, die Gallium einschließt, und eines polykristallinen Siliziums;
Einspeisen der Mischung in einen Tiegel eines Einkristallofens;
Einleiten eines Dotiergases, das mindestens eine erste Menge an Stickstoff einschließt, in die Mischungsschmelze durch den Einkristallofen, wobei ein erstes Verhältnis der ersten Menge an Stickstoff zu dem Dotiergas größer als oder gleich 0,8 ist;
Bereitstellen eines Kristallkeims zu der geschmolzenen Mischung;
Herausziehen des Kristallkeims aus der geschmolzenen Mischung, während das Dotiergas, das eine zweite Menge an Stickstoff einschließt, in die geschmolzene Mischung eingeleitet wird, wobei ein zweites Verhältnis der zweiten Menge an Stickstoff zu dem Dotiergas kleiner als oder gleich 0,1 ist; und
Ausbilden, unter einer Atmosphäre des Dotiergases, eines monokristallinen Siliziumstabs durch Kristallisieren der geschmolzenen Mischung um den Kristallkein herum und unter diesem, während der Kristallkeim aus der geschmolzenen Mischung kontinuierlich herausgezogen wird, wobei bei einem Auftreten einer Schulter des monokristallinen Siliziumstabs die zweite Menge an Stickstoff auf eine dritte Menge auf eine Weise eingestellt wird, dass ein drittes Verhältnis der dritten Menge an Stickstoff zu dem Dotiergas größer als das zweite Verhältnis ist, und das dritte Verhältnis größer als oder gleich 0,8 ist.

2. Verfahren nach Anspruch 1, wobei der ausgebildete monokristalline Siliziumstab Dotierstoffe umfasst, die das Gallium und den Stickstoff einschließen, wobei eine Dotierkonzentration des Galliums in einem Bereich von 0,001 Ω cm bis 100 Ω cm liegt und eine Dotierkonzentration des Stickstoffs in einem Bereich von 0,01 ppma bis 0,1 ppma liegt.

3. Verfahren nach Anspruch 1, wobei der ausgebildete monokristalline Silizumstab Dotierstoffe umfasst, die das Gallium und den Stickstoff einschließen, wobei eine Dotierkonzentration des Galliums in einem Bereich von 0,001 Ω cm bis 10 Ω cm liegt und eine Dotierkonzentration des Stickstoffs in einem Bereich von 0,01 ppma bis 0,1 ppma liegt.

4. Verfahren nach Anspruch 1, wobei die Dotierquelle, die Gallium einschließt, metallisches Gallium ist.

5. Verfahren nach Anspruch 1, wobei das Dotiergas ferner Argon umfasst, wobei der Stickstoff und das Argon in den Einkristallofen über mindestens eines eingeleitet werden von:
(1) Einleiten des Stickstoffs und des Argons aus unabhängigen Stickstoff- und Argonquellen, die jeweils mit unabhängigen Massendurchflussmessern verbunden sind, über eine Dreiwegerohrleitung in den Einkristallofen, und Verwenden der Massendurchflussmesser, um die Durchflussraten des Argons und des Stickstoffs jeweils zu steuern;
(2) Einleiten des Stickstoffs und des Argons aus den unabhängigen Stickstoff- und Argonquellen in den Einkristallofen jeweils über einen einstellbaren Stickstoffeinlass und einen einstellbaren Argoneinlass, die an dem Einkristallofen bereitgestellt sind; oder
(3) Mischen des Stickstoffs und des Argons aus den unabhängigen Stickstoff- und Argonquellen in einem zuvor bestimmten Verhältnis und Einleiten des gemischten Stickstoff- und Argongases in den Einkristallofen.

## Revendications

1. Procédé permettant de préparer un silicium monocristallin à l'aide d'un procédé de Czochralski, comprenant :
l'obtention d'un mélange en mélangeant une source de dopage comportant du gallium et un silicium polycristallin ;
l'introduction du mélange dans un creuset d'un four monocristallin ;
l'introduction d'un gaz de dopage comportant au moins une première quantité d'azote dans le mélange fondu par le four monocristallin, dans lequel un premier rapport entre la première quantité d'azote et le gaz de dopage est supérieur ou égal à 0,8 ;
la fourniture d'une graine au mélange fondu ;
le retrait de la graine du mélange fondu tout en introduisant le gaz de dopage comportant une deuxième quantité d'azote dans le mélange fondu, dans lequel un deuxième rapport de la deuxième quantité d'azote au gaz de dopage est inférieur ou égal à 0,1 ; et
la formation, sous une atmosphère du gaz de dopage, d'une tige de silicium monocristallin par cristallisation du mélange fondu autour et en dessous de la graine tandis que la graine est continuellement retirée du mélange fondu, dans lequel lorsqu'un épaulement de la tige de silicium monocristallin se produit, la deuxième quantité d'azote est ajustée à une troisième quantité de manière à ce qu'un troisième rapport entre la troisième quantité d'azote et le gaz de dopage soit supérieur au deuxième rapport, et le troisième rapport est supérieur ou égal à 0,8.

2. Procédé selon la revendication 1, dans lequel la tige de silicium monocristallin formée comprend des dopants comportant le gallium et l'azote, une concentration de dopage du gallium étant dans une plage de 0,001 Ω cm à 100 Ω cm et une concentration de dopage de l'azote étant dans une plage de 0,01 ppma à 0,1 ppma.

3. Procédé selon la revendication 1, dans lequel la tige de silicium monocristallin formée comprend des dopants comportant le gallium et l'azote, une concentration de dopage du gallium étant dans une plage de 0,001 Ω cm à 10 Ω cm et une concentration de dopage de l'azote étant dans une plage de 0,01 ppma à 0,1 ppma.

4. Procédé selon la revendication 1, dans lequel la source de dopage comportant du gallium est du gallium métallique.

5. Procédé selon la revendication 1, dans lequel le gaz de dopage comprend en outre de l'argon, dans lequel l'azote et l'argon sont introduits dans le four monocristallin par au moins l'un parmi :
(1) l'introduction de l'azote et de l'argon provenant de sources indépendantes d'azote et d'argon reliées respectivement à des débitmètres massiques indépendants dans le four monocristallin par une canalisation à trois voies, et l'utilisation des débitmètres massiques pour commander respectivement des débits de l'argon et de l'azote ;
(2) l'introduction de l'azote et de l'argon provenant des sources indépendantes d'azote et d'argon dans le four monocristallin respectivement par une entrée d'azote réglable et une entrée d'argon réglable prévues sur le four monocristallin ; ou
(3) le mélange de l'azote et de l'argon provenant des sources indépendantes d'azote et d'argon dans un rapport prédéterminé, et l'introduction du mélange d'azote et d'argon gazeux dans le four monocristallin.
